## Europäisches Patentamt

## European Patent Office

## Office européen des brevets

(19)

(11) Veröffentlichungsnummer: **0 113 794**
**B1**

(12) **EUROPÄISCHE PATENTSCHRIFT**

(45) Veröffentlichungstag der Patentschrift:
**08.04.87**

(51) Int. Cl.⁴: **H 05 K 7/20**

(21) Anmeldenummer: **83104868.1**

(22) Anmeldetag: **17.05.83**

(54) **Baugruppenträger.**

(30) Priorität: **21.12.82 DE 3247240**

(43) Veröffentlichungstag der Anmeldung:
**25.07.84 Patentblatt 84/30**

(45) Bekanntmachung des Hinweises auf die Patenterteilung:
**08.04.87 Patentblatt 87/15**

(84) Benannte Vertragsstaaten:
**AT BE CH DE FR GB IT LI NL**

(56) Entgegenhaltungen:
**DE-A-2 347 751**
**DE-B-2 345 626**
**DE-U-8 221 756**
**GB-A-1 365 877**
**US-A-3 267 333**

(73) Patentinhaber: **Siemens Aktiengesellschaft Berlin und München, Wittelsbacherplatz 2, D-8000 München 2 (DE)**

(72) Erfinder: **Wessely, Herrmann, Dipl.- Ing., Paul-Hösch- Strasse 1, D-8000 München 60 (DE)**

LIBER, STOCKHOLM 1987

EP 0 113 794 B1

**Beschreibung**

Die Erfindung betrifft einen Baugruppenträger gemäß dem Oberbegriff des Anspruchs 1.

Die zunehmende Miniaturisierung von intergrierten Bausteinen und eine hohe Packungsdichte haben eine starke Wärmeabgabe der Bausteine zur Folge, die leicht zur Überschreitung der zulässigen Bausteintemperaturen führen kann. Zur Kühlung über Konvektion an die umgebende Luft ist aus der DE-OS 23 47 751 bekannt, planar auf eine Verdrahtungsplatte aufstrecke Flachbaugruppen jeweils mit einer großflächigen Metallplatte zu versehen, die in thermischem Kontakt mit den Bausteinen steht. Sie ist mit einer Seite nach außen weisend in ein die Flachbaugruppe einfassendes Steckverbinderteil eingebettet.

Auf dem Prinzip der Luftkühlung beruht auch die aus dem Gebrauchsmuster (DE-U- 82 21 756) bekannte Einrichtung zur Wärmeableitung bei der auf einer Gruppe von thermisch belasteten flächigen Bauelementen mit jeweils einem ersten Kühlkörper, ein gemeinsamer zweiter Kühlkörper angeordnet ist, der die von den einzelnen Bauelementen erzeugte Wärme aufnimmt und an ein außerhalb des Gehäuses liegendes Kühlprofil weiterleitet. Dieses Kühlprofil bewirkt dann die eigentliche Kühlung durch Wärmeaustausch mit der Luft.

Aus der US-PS 3 993 123 ist ferner eine Kühleinrichtung für einen oder mehrere wärmeabgebende Elektronikbausteine bekannt, die auf einer Seite eines flachen Trägers ankontaktiert sind. Die Bausteine liegen mit thermischem Kontakt unter einer wärmeleitenden Kamme, auf der ein von Kühlflüssigkeit durchströmter, annähernd bündig mit dem Träger abschließender Kühlkörmer angeflanscht ist. Wenn jedoch eine größere Anzahl derartiger Einrichtungen auf einer Leiterplatte angeordnet sind, so muß zumindest eine entsprechend große Anzahl von Leitungsstücken vorgesehen sein, um die Versorgung aller Kühlmittelkreisläufe sicherzustellen. Das kann jedoch einen erheblichen Aufwand für die Montage und die Wartung erfordern.

Weiterhin ist aus der DE-OS 29 26 076 eine Anordnung zum Kühlen von elektronischen Bausteinen bekannt, bei welcher die Verlustwärme über wärmeleitende Bahnen einer Trägerkarte auf einen, mehrere Karten in paralleler Anordnung aufnehmenden Einsteckrahmen und von dort auf eine als Kühlkörper dienende Gehäusewand abgeleitet wird. Den Einateckrahmen umgibt zur Halterung und Abdeckung ein Aufbau, der auf die Gehäusewand aufgesetzt ist, und in dessen Inneren sich Federnso gegen den Einsteckrahmen abstützen, daß dieser gegen die Gehäusewandgedrückt wird. Auf diese Weise entstehen jedoch lange Wärmedurchgangsstrecken und mehrere Wärmeübergänge, so daß die Kühlwirkung relativ gering ist. Außerdem besteht die Gefahr, daß der Wärmekontakt zwischen dem Rahmen und der Gehäusewand bei mechanischen Erschütterungen unterbrochen wird, da er lediglich von den Federkräften abhängt, die jedoch aus Rücksicht auf die mechanische Festigkeit des Aufbaus nicht beliebig groß sein können.

Aus der DE-B- 23 45 626 ist eine Einrichtung zum Kühlen elektronischer Geräte bekannt, die einen mit einem Kühlmedium durchströmten Kühlkörper aufweist, dessen beidseitig großflächigen aktiven Kühlflächen aus elastischen Membranen bestehen, die zur Versteifung mit einem flachen Stützgitter abgestützt sind. An diesem Kühlkörper sind über stirnseitig angebrachte Gelenkvorrichtungen schwenkbare, an der dem Kühlkörper abgewandten Seite mit einer Verdrahtungsplatine verbundene Gitterrahmen befestigt, in dessen Fenster die zu kühlenden Bauelemente mit einem ersten Kühlkörper eingelegt und mit der Verdrahtungsplatine durch spezielle Kontaktvorrichtung kontaktiert werden. Anschließend wird die Einheit, bestehend aus Gitterrahmen, Verdrahtungsplatine und Bauteile zum Kühlkörper hin eingeschwenkt und mit den der Gelenkseite gegenüberliegenden Seite angebrachten Verriegelungsteilen befestigt. Durch den leichten Überdruck des Kühlmediums wird die Kühlmembran etwas nach außen gedrückt, wobei sie durch das flache Stützgitter zum Teil zurückgehalten werden. Es entstehen innerhalb der Fenster des flachen Stützgitters kleine Ausbeulungen, durch die die Toleranzschwankungen bezüglich der Dicken der einzelnen Bauelemente mit den ersten Kühlkörpern ausgeglichen werden. Somit tritt jedes einzelne Bauelement in individuell starken Kontakt mit dem zweiten Kühlkörper.

Der Erfindung lag daher die Aufgabe zugrunde, einen Baugruppenträger der oben genannten Art anzugeben, welcher sich durch einen einfachen Aufbau auszeichnet, und welcher einen guten und gleichmäßigen Wärmekontakt zwischen den ersten Kuhikormern und dem zweiten Kühlkörper gewährleistet.

Erfindungsgemäß wird die Aufgabe durch die im Kennzeichen des Hauptanspruchs festgehaltenen Merkmale gelöst.

Der Erfindung hat den Vorteil daß der Baugruppenträger einfach montiert werden kann, und daß die einzelnen Flachbaugrummen leicht auswechselbar sind.

Der Abstand zwischen der Verdrahtungsplatte und den zweiten Kühlkörpern ist größer als die Höhe der Flachbaugruppen einschließlich der ersten Kühlkörmer, dadurch wird ein Heranziehen der ersten Kühlkörmer an den zweiten Kühlkörmer ein für alle Flachbaugruppen gleich großer Anpreßdruck erzeugt. Dies wird erreicht, da die Klemmverbindungselemente jeweils mittig auf den ersten Kühlkörpern angeordnet sind. Dabei bestehen die Klemmverbindungselemente vorteilhafterweise aus Schrauben.

Eine ebene Ausrichtung der ersten zum zweiten Kühlkörmer wird dadurch erreicht, daß dieser jeweils an den Kreuzungsmunkten des Gitterrahmens verschraubt ist. Durch mindestens einen Zentrierbolzen auf dem Gitterrahmen und eine den Zentrierbolzen aufnehmende Aussmarung im zweiten Kühlkörper werden die einander entsprechenden Teile der Klemmverbindungselemente vor dem Verbinden zueinander ausgerichtet, und erleichtern dadurch die Montage. Besonders wenn eine aus einer Einhängelasche und einem Einhängebolzen bestehende lösbare Einhängevorrichtung zwischen dem Gitterrahmen und dem zweiten Kühlkörper vorgesehen ist, ist ein schnelles Anbringen der Klemmverbindung gewährleistet.

Eine vorteilhafte Weiterbildung der Erfindung ist durch eine ortfeste Verbindung des zweiten Kühlkörpers mit einem Gehäuserahmen gekennzeichnet.

Im folgenden wird die Erfindung anhand eines bevorzugten Ausführungsbeispiels weiter beschrieben.

Figur 1 zeigt einen Baugruppenträger

Figur 2 zeigt einen Querschnitt durch den Baugruppenträger aus Figur 1.

Wie die beiden Figuren zeigen, besteht der Baugruppenträger aus einer Verdrahtungsplatte 19, aus einem Gitterrahmen 6, aus mehreren Flachbaugruppen 1, die jeweils mit einem ersten Kühlkörper 7 versehen sind, und aus einem zweiten Kühlkörper 12, welcher allen ersten Kühlkörpern gemeinsam zugeordnet ist.

Die Flachbaugruppen 1 sind in ihrer äußeren Form durch ein Steckverbinderteil bestimmt, welches die vier schmalen Ränder der Flachbaugruppe 1 einfaßt, und auf dessen einer Flachseite Kontaktelemente 2' in rasterartig verteilte Aussparungen eingesetzt sind. Auf der zweiten Flachseite ist ein erster Kühlkörper 7 in das Steckverbindérteil eingebettet, wobei ein schmaler, bündig mit dem ersten Kühlkörper 7 abschließender Kragen entsteht. Im Inneren der Flachbaugruppen 1 liegen, nicht sichtbar, integrierte elektronische Bausteine mit direktem thermischen Kontakt zu den ersten Kühlkörpern 7.

Die Kontaktelemente 2' bestehen aus Stiften oder Kontaktfedern, deren Gegenstücke 2 innerhalb eines Gitterzwischenraums auf der Verdrahtungsplatte 19 befestigt sind. Zur Veranschaulichung ist eine der Flachbaugruppen 1 in Pfeilrichtung aus dem zugehörigen Gitterzwischenraum nach oben herausgeklappt, und gibt somit die Sicht frei auf die Kontaktelemente 2' und ihre Gegenstücke 2. Die übrigen Flachbaugruppen 1 sind in planarer Anordnung jeweils so in die Gitterzwischenräume gesteckt, daß die ersten Kühlkörper 7 mit ihren, der Leiterplatte 19 abgewandten Außenflächen zum zweiten Kühlkörper 12 weisen.

Dieser besteht aus einem stabilen, metallischen Hohlkörper, welcher auf der baugruppenzugewandten Seite höchste Ebenheit aufweist. Er ist ortsfestmit einem Rückkühlsystem und mit einem Gehäuserahmen (beide nicht dargestellt) verbunden. In seinem Inneren zirkuliert, angetrieben vom Rückkühlsystem, ein flüssiges oder gasförmiges Kühlmittel. Der Gehäuserahmen kann auch weitere derartige Baugruppenträger aufnehmen.

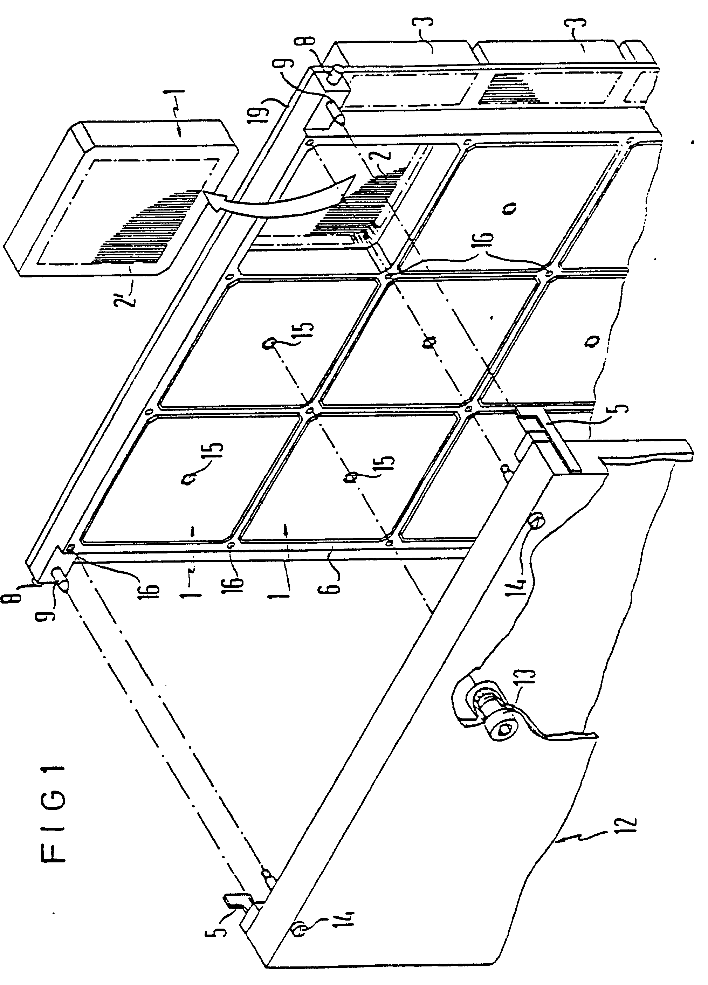

Wie aus der explosionsartigen Darstellung der Figur 1 zu entnehmen ist, hat der zweite Kühlkörper 12 etwa die Seitenlängen des Gitterrahmens 6 und bedeckt deshalb alle ersten Kühlkörper 1. An den vier Ecken des zweiten Kühlkörpers 12 sind Einhängelaschen 5 befestigt, in welche die Funktionseinheit, bestehend aus Leiterplatte 19, Gitterrahmen 6, und Flachbaugruppen 1 mittels Zapfen 8 eingehängt ist, die seitlich vom Gitterrahmen 6 abstehen. Außerdem ist der zweite Kühlkörper 12 mit Schrauben 14, die in Gewindebohrungen 16 an den Kreuzungspunkten des Gitterrahmens 6 eingedreht sind, mit dem Gitterrahmen 6 verschraubt. Jeder einzelne erste Kühlkörper 1 ist an den zweiten Kühlkörper 12 jeweils durch ein Klemmverbindungselement 13 gepreßt, das aus einer Schraube besteht, die durch den zweiten Kühlkörper 12 gesteckt ist, und die in eine mittig auf den ersten Kühlkörper 7 angebrachte Gewindebohrung 15 eingreift. Eine Vorzentrierung der Schraubverbindungen erfolgt durch lotrecht vom Gitterrahimen 6 abstehende, angefaßte Bolzen 9, die von entsprechenden Aussparungen im ersten Kühlkörper 12 aufgenommen werden. Zum Anschließen von Signalleitungen dienen Steckerbuchsen 3 am Rand der Verdrahtungsplatte 19.

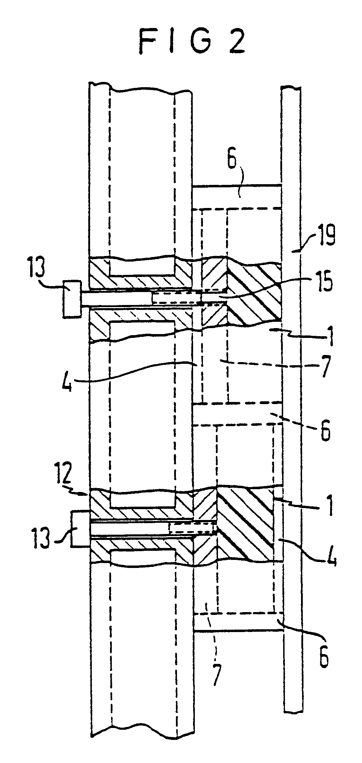

Die obere Hälfte der Figur 2 zeigt eine noch offene Klemmverbindung zwischen einem ersten Kühlkörper 1 und dem zweiten Kühlkörper 12, während in der unteren Hälfte der Figur die Klemmverbindung angezogen ist und einen engen, flächigen thermischen Kontakt zwischen den beiden Kühlkörpern erzeugt. Im folgenden wird anhand der Figur die Montage des Baugruppenträgers beschrieben. Nach dem Einsetzen aller Flachbaugruppen 1 in die Zwischenräume des Gitterrahmens 6 wird dieser in die Einhängelaschen 5 an dem zweiten Kühlkörper 12 eingehängt, iobei eine Vorzentrierung durch die Bolzen 9 erfolgt. Da der durch die Höhe des Gitterrahmens 6 bestimmte Abstand zwischen der Leiterplatte 19 und den zweiten Kühlkörper 12 größer ist als die Höhe der Flachbaugruppen 1, bleibt zwischen diesen und dem zweiten Kühlkörper 12 ein kleiner definierter Zwischenraum 4, dessen relative Größe in der Zeicnnung übertrieben wiedergegeben ist. Nach dem Verschrauben des zweiten Kühlkörpers 12 auf dem Gitterrahmen 6 wird jede einzelne Flachbaugruppe durch das Anziehen der Klemmverbindungen 13 um die dem Zwischenraum 4 entsprechende Weglänge von der Leiterplatte 19 weggezogen, wobei alle ersten Kühlkörper 7 an den zweites Kühlkörper 12 gepreßt werden. Da nun der Zwischenraum 4 zwischen die Flachbaugruppen 1 und die Leiterplatte 19 verlagert ist, muß eine ausreichende galvanische Verbindung durch eine entsprechende Bemessung der Kontaktelemente 2' und ihrer Gegenstücke 2 gewährleistet sein. Die Kühlung der Bausteine erfolgt durch Wärmeabgabe an die ersten Kühlkörper 1 und über Zwangskonvektion an das Kühlmedium im zweiten Kühlkörmer 12 Dabei ist der Wärmewiderstand durch Auftragen eines Wärmeleitfettes auf die Berührungsflächen herabgesetzt.


**Patentansprüche**

1. Baugruppenträger mit mehreren in den Zwischenräumen eines auf einer Verdrahtungsplatte befestigten Gitterrahmens liegenden und in Planaranordnung auf der Verdrahtungsplatte angeordneten Baugruppen, mit diesen Baugruppen zugeordneten ersten Kühlkörpern, und mit einem hohlen und von einem Kühlmedium durchströmten zweiten Kühlkörper, an welchem alle ersten Kühlkörper gemeinsam lösbar angebracht sind, dadurch gekennzeichnet, daß der zweite Kühlkörper (12) mit dem Gitterrahmen (6) jeweils an den Kreuzungspunkten des Gitterrahmens (6) mit Klemmverbindungselementen lösbar verbunden ist, daß die Höhe des Gitterrahmens (6) höher ist als die Höhe der Flachbaugruppen (1) einschließlich ihrer ersten Kühlkörper, so daß die galvanische Verbindung zwischen den Kontaktelementen (2') und ihren Gegenstücken (2) gewährleistet bleibt, und daß die ersten Kühlkörper (7) jeweils mittig mit dem zweiten Kühlkörper (12) durch ein lösbares Klemmverbindungselement (13) verbunden sind.

2. Baugruppenträger nach Anspruch 1, dadurch gekennzeichnet , daß die Klemmverbindungselemente (13) aus Schrauben bestehen.

3. Baugruppenträger nach Anspruch 1 oder 2, gekennzeichnet durch mindestens einen Zentrierbolzen (9) auf dem Gitterrahmen (6) und eine den Zentrierbolzen (9) aufnehmende Aussparung im zweiten Kühlkörper (12).

4. Baugruppenträger nach einem der vorhergehenden Ansprüche, gekennzeichnet durch eine aus einer Einhängelasche (5) und einem Einhängebolzen (8) bestehende Einhängevorrichtung zwischen dem Gitterrahmen (6) und dem zweiten Kühlkörper (12).

5. Baugruppenträger nach einem der vorhergehenden Ansprüche, gekennzeichnet durch eine ortsfeste Verbindung des zweiten Kühlkörpers (12) mit einem Gehäuserahmen.


**Claims**

1. A structural component carrier comprising a plurality of structural components which are arranged in a planar array in the interstices of a grid frame, which is secured on a wiring plate, and comprising first cooling bodies assigned to said structural components and comprising a hollow second cooling body through which a cooling medium passes and to which all first cooling bodies are secured so as to be commonly detachable, characterised in that the second cooling body (12) is detachably connected to the grid frame (6) by means of clamping connection elements at the intersections of the grid frame (6), that the thickness of the grid frame (6) is greater than the thickness of the flat structural components (1) including their first cooling bodies, so that galvanic connection between the contact elements (2') and the counterpieces (2) thereof remains ensured, and that the first cooling bodies (7) are respectively centrally connected to the second cooling bodies (12) by means of a detachable clamping connection element (13).

2. A structural component carrier as claimed in Claim 1, characterised in that the clamping connection elements (13) are screws.

3. A structural component carrier as claimed in Claim 1 or 2, characterised by at least one centering stud (9) on the grid frame (6) and a recess, which accommodates the centering stud (9), in the second cooling body (12).

4. A structural component carrier as claimed in one of the preceding Claims, characterised by a suspension device, which consists of a suspension clip (5) and a suspension stud (8), between the grid frame (6) and the second cooling body (12).

5. A structural component carrier as claimed in one of the preceding Claims, characterised by a fixed connection of the second cooling body (12) to a housing frame.


**Revendications**

1. Support pour modules, comportant plusieurs modules situés dans les espaces intercalaires d'un cadre formant grille fixé à une plaque de câblage, et disposés selon un arrangement plan sur la plaque de câblage, des premiers éléments de refroidissement associés à ces modules et un second élément de refroidissement creux parcouru par un fluide de refroidissement et sur lequel l'ensemble des premiers éléments de refroidissement sont montés en commun de façon détachable, caractérisé par le fait que le second élément de refroidissement (12) est relié de façon détachable au cadre (6) formant grille, respectivement au niveau du point d'intersection de ce cadre (6) avec des organes de liaison par serrage, que la hauteur du cadre (6) de la grille est supérieure à la hauteur des modules plats (1), y compris leurs premiers éléments de refroidissement de sorte que la liaison galvanique entre les organes de contact (2') et les éléments antagonistes (2), qui leur sont associés, reste garantie, et que les premiers éléments de refroidissement (7) sont reliés respectivement, au niveau de leur centre, aux seconds éléments de refroidissement (12), par un organe détachable de liaison par serrage (13).

2. Support pour modules suivant la revendication 1, caractérisé par le fait que les organes de liaison par serrage (13) sont constitués par des vis.

3. Support pour modules suivant la revendication 1 ou 2, caractérisé par au moins un boulon de centrage (9) monté sur le cadre en forme de grille (6) et par un évidement logeant le boulon de centrage (9) et situé dans le second élément de refroidissement (12).

4. Support pour modules suivant l'une des revendications précédentes, caractérisé par un dispositif de suspension constitué par une patte d'accrochage (5) et un téton d'accrochage (8) et disposé entre le cadreformant grille (6) et le second élément de refroidissement (12).

5. Support pour module suivant l'une des revendications précédentes, caractérisé par une liaison fixe du second élément de refroidissement (12) à un cadre formant boîtier.

FIG 1

# F I G 2